# EUROPEAN PATENT APPLICATION

(11) **EP 2 466 194 A1**
(43) Date of publication of application: **20.06.2012**
(21) Application number: 11747003.9
(22) Date of filing: 17.02.2011
(51) Int. Cl.: F21S 2/00, F21Y 101/02

(54) **LAMP WITH BASE, AND ILLUMINATION DEVICE**

(30) Priority: 23.02.2010 JP 2010037510
(71) Applicant: Toshiba Lighting&Technology Corporation, Yokosuka-shi, Kanagawa 237-8510 (JP); Kabushiki Kaisha Toshiba, Minato-ku, Tokyo 105-8001 (JP)
(72) Inventor: BETSUDA, Nobuhiko, Yokosuka-shi Kanagawa 237-8510 (JP); NISHIMURA, Kiyoshi, Yokosuka-shi Kanagawa 237-8510 (JP); SHIBANO, Nobuo, Yokosuka-shi Kanagawa 237-8510 (JP); SEGAWA, Masao, Yokosuka-shi Kanagawa 237-8510 (JP); MATSUDA, Shuhei, Yokosuka-shi Kanagawa 237-8510 (JP); SHIBUSAWA, Soichi, Yokosuka-shi Kanagawa 237-8510 (JP)
(74) Representative: Sander Jakobsson, Sofia Ellinor
(86) International application number: PCT/JP2011/000877
(87) International publication number: WO 2011/105030

(57) **Abstract**

A lamp with ferrule 10 includes a substrate 12 in which a solid light-emitting device 11 is implemented on one surface side thereof, a thermal radiation member 14 which is fixed to the other surface side of the substrate 12 by a fluid fixing member 13 having thermal conductivity; a light-emitting portion 15 constituted by the substrate 12 and the thermal radiation member 14; a thermally conductive support member 17 which constitutes a three-dimensional light source body 16 using a plurality of light-emitting portions 15; a thermally conductive main body 18 which is provided with the support member 17 so as to project the three-dimensional light source body 16 to the one end portion side; and a ferrule member 19 that is provided on the other end portion side of the main body 18.

## Description

### TECHNICAL FIELD

The present invention relates to a lamp with ferrule which uses a solid light-emitting device such as a light-emitting diode as a light source and a lighting apparatus using the lamp with ferrule.

### Background Art

In recent years, on behalf of a filament bulb, a lamp with ferrule such as a bulb-like LED lamp, which uses a light-emitting diode, that is, a solid light-emitting device with long life or low power consumption as a light source, has been adopted as a light source of various lighting apparatuses. In the lamp with ferrule of the related art, for example, as disclosed in a patent literature 1, the light-emitting diode as the light source is placed and configured in a plane shape on a surface of a substrate formed of a circular plate. For this reason, since light emitted from the light-emitting diode is mainly emitted to a front surface side, the same light distribution characteristics as those of an electrical bulb are not obtained, and particularly, the uniform light distribution characteristics in all directions including a back surface (a surface of a ferrule side) are not obtained. As a result, when incorporating the lamp with ferrule including the light-emitting device replaceable with the electrical bulb into the lighting apparatus, in a lighting apparatus having a reflection plate which is optically designed by originally using the electrical bulb as the light source, there was a problem in that it is impossible to obtain sufficient reflective performance as the optical design.

In order to solve the problem, for example, a patent literature 1, particularly, paragraph number [0004] and [0005] discloses a LED bulb which can be operated so that a continuous and uniform illumination of high flux is obtained. A LED bulb is disclosed in which a substrate has a regular polyhedron of at least four surfaces. The surface of the polyhedron is provided with at least one LED having the flux of at least 5 1m during operation of the bulb, and a gear pillar is provided with heat dissipation means for mutually connecting the substrate with the bulb ferrule.

Meanwhile, in this type lamp with ferrule, in order to allow the substitution of the electric bulb, bulb-like lamps with ferrule of various sizes are desired. In order to obtain desired characteristics by accommodating a light emitting portion in an inner portion of the lamp with ferrule of various sizes, there is a need to further improve the light emitting efficiency of the light-emitting diode, and a further improvement of heat dissipation is required in the substrate and the lamp main body. In addition to that, in recent years, there has been a need for the same optical characteristics as those of the electric bulb, and there is a need to achieve the same characteristics of a 1/2 beam angle of 200° or more as those of the electric bulb so as to solve the problem mentioned above even in the light distribution characteristics as well as the total flux.

Furthermore, as disclosed in a patent literature 2, in a case where the light-emitting diode is placed on the surface of the substrate constituted by a circular plate, the substrate is attached to a base formed of aluminum or the like, and the base is directly connected to a cover (a main body) formed of aluminum. The heat can be radiated via the main body (see the patent literature 2, paragraph number [0029])

However, as disclosed in the patent literature 1, in the case of forming a cubic shape having planes of six surfaces, it is impossible to directly connect the substrate with the light-emitting diode fixed thereto and the main body. For this reason, in the patent literature 1, heat dissipation means including a metallic connection portion is provided between the substrate and the bulb ferrule. Specifically, an outer surface of the gear pillar is formed of metal or metal alloy. The substrate formed of metal is assembled in the cubic shape, and the substrate is connected to the gear pillar of the top of the cube to form heat dissipation means (see the patent literature 1, paragraph numbers [0020] and [0023]).
In order to connect the cube with the gear pillar, there is a need to use fixing means for reliably connecting them without damaging the thermal conductivity of both components. As the fixing means, fixing through solder also having good thermal conductivity is performed. However, when fixing by pouring the solder between the three-dimensional substrate and the gear pillar, the solder has fluidity and flows from a portion to be connected before being solidified. For this reason, there is a problem in that the work is extremely difficult, which is unsuitable for mass production. In this regard, paragraph number [0023] of the patent literature 1 only discloses "connected to the gear pillar via the top of the cube", but does not disclose how to fix, and therefore fails in the improvement.

### CITATION LIST

### Patent Literature

Patent literature 1: Japanese Patent No. 4290887
Patent literature 2: JP-A-2008-91140

### BRIEF DESCRIPTION OF DRWINGS

Fig. 1 shows a lamp with a ferrule according to an embodiment of the present invention, (a) is a perspective view that shows a state where a three-dimensional light source is provided on one end portion side of a main body, (b) is a cross-sectional view of a light-emitting portion.
Fig. 2 is a perspective view that shows a state where a light source body of the lamp with ferrule is supported on a support member.
Fig. 3 shows the lamp with ferrule, (a) is a top view showing a state where a cover member is detached, and (b) is a longitudinal cross-sectional view.

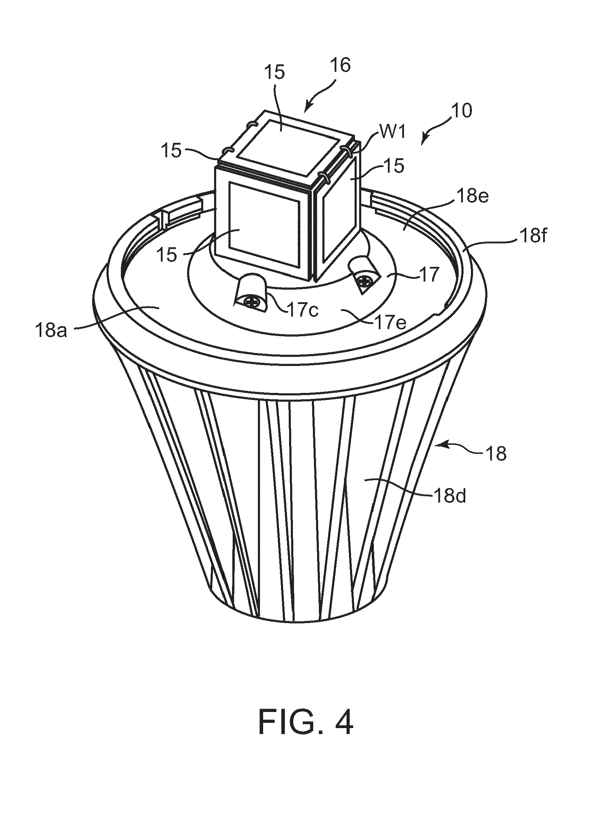

Fig. 4 is a perspective view that similarly shows the lamp with ferrule in a state where the cover member is detached.
Fig. 5 is a cross-sectional view schematically shows a state where a lighting apparatus with the lamp with ferrule mounted thereon is placed on a ceiling.
Fig. 6 is a longitudinal cross-sectional view that shows a first modified example of the lamp with ferrule.
Fig. 7 shows a further modified example of the lamp with ferrule, (a) is a perspective view that corresponds to Fig. 2 in the second modified example, and (b) is a front view that shows the light-emitting portion of a third modified example in an exploded manner.
Fig. 8 is a perspective view that shows a fourth modified example of the lamp with ferrule in the state where the cover member is detached.
Fig. 9 is a perspective view that shows a filth modified example of the lamp with ferrule in the state where the cover member is detached.
Fig. 10 is a longitudinal cross-sectional view that shows a sixth modified example of the lamp with ferrule.

### DESCRIPTION OF EMBODIMENTS

A lamp with ferrule according to an embodiment, a lamp with a ferrule includes: a substrate including a solid light-emitting device implemented on one surface side thereof; a thermal radiation member fixed to the other surface side of the substrate by a fluid fixing member having thermal conductivity; a light-emitting portion constituted by the substrate and the thermal radiation member; a thermally conductive support member for constituting a three-dimensional light source body using a plurality of light-emitting portions, and thermally coupling and supporting the thermal radiation member; a thermally conductive main body provided with the support member so as to project the three-dimensional light source body to the one end portion side thereof; and a ferrule member provided on the other end portion side of the main body.

Hereinafter, an embodiment of a lamp with ferrule and a lighting apparatus according to the present invention will be described with reference to the drawings. In addition, in the specification and each drawing, the components similar to those issued in regard to the previous drawings are denoted by the same reference numerals and the detailed descriptions thereof will be suitably omitted.

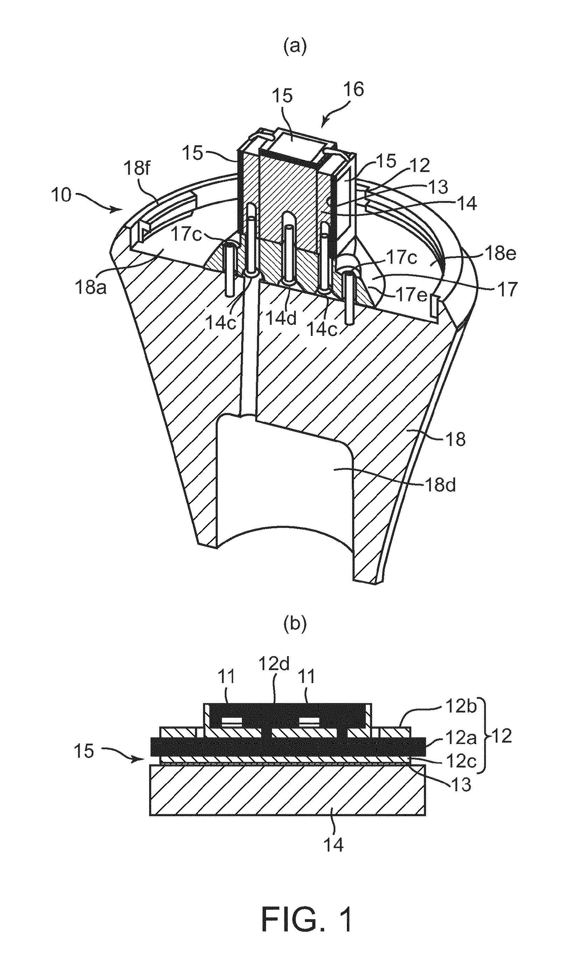

Figs. 1 to 3 show a lamp with ferrule according to an embodiment of the present invention, which constitutes a bulb-shaped lamp with ferrule 10 having a shape similar to an electric bulb. As shown in Fig. 1, the lamp with ferrule includes a substrate 12 in which a solid light-emitting device 11 is implemented on one surface side; a thermal radiation member 14 which is fixed to the other surface side of the substrate by a fluid fixing member 13 having thermal conductivity; a light-emitting portion 15 constituted by the substrate 12 and the thermal radiation member 14; a thermally conductive support member 17 which constitutes a three-dimensional light source body 16 by multifacetedly placing a plurality of light-emitting portions 15, thermally couples and supports the thermal radiation member 14; a thermally conductive main body 18 which is provided with the support member 17 so as to project the three-dimensional light source body 16 to the one end portion side; a ferrule member 19 that is provided on the other end portion side of the main body 18; a lighting device 20 which is provided so as to be accommodated in the main body 18 and turns on the solid light-emitting device 11; and a cover member 21 which constitutes the globe.

As shown in Fig. 1(b), the solid light-emitting device 11 is constituted by a light-emitting diode chip (hereinafter, referred to as a "LED chip") in the present embodiment. The LED chip 11 is constituted by a plurality of LED chips having the same performance, in the present embodiment, a blue LED chip having high brightness and high output.

The solid light-emitting device 11 includes a light-emitting diode, a semiconductor laser, and a solid light-emitting device such as an organic EL device. In the solid light-emitting device 11 implemented on one side of the substrate 12, a plurality of solid light-emitting devices 11, for example, the light-emitting diode is placed and implemented regularly and in a certain order such as a matrix shape and a zigzag shape or a radial shape, for example, on a square substrate 12 partially or as a whole in a plane shape, for example, using a COB (Chip on Board) technique. However, one or a plurality of light-emitting diodes may be placed and implemented in a plane shape using a SMD (Surface Mount Device) type.

The substrate 12 is constituted by a DCB (Direct Copper Binding) substrate, that is, a composite ceramic substrate from the viewpoint of thermal conductivity and electrical insulation. The substrate 12 includes a ceramic substrate 12a to become a ceramic core, a metal pattern 12b for forming a wiring pattern formed of a copper plate provided on one surface side (hereinafter, referred to as a "surface side") of the ceramic substrate 12a, a LED chip 11 implemented on the surface side of the metal pattern 12b, and a metallic member 12c formed of copper plate provided on the other surface side (hereinafter referred to as a "back side") of the substrate 12. The ceramic substrate 12a is constituted by a flat plate which is formed of alumina and has a substantially square shape with one side of about 15 mm and a thickness of about 0.32 mm in the present embodiment.

As the substrate 12, from the viewpoint of thermal conductivity and electrical insulation, it is preferable to use a DCB substrate constituted by ceramic formed of a sintered body such as aluminum nitride, silicon carbide, alumina, a composite of alumina, zirconia or the like. However, the substrate may be formed of a metal having satisfactory thermal conductivity such as aluminum and copper. Furthermore, the substrate may be formed of synthetic resin such as epoxy resin and glass epoxy and may be constituted to have flexibility. Furthermore, in order to form the three-dimensional light source body such as a prism, the shape of the substrate 12 is preferably formed in a rectangular shape such as a square or rectangle, but it is possible to adopt various shapes for obtaining the targeted light distribution characteristics such as a triangular shape for forming a triangular cone.

The metallic pattern 12b is bonded to the surface side of the ceramic substrate 12a by the solder so as to form the wiring pattern. The thickness of the metallic pattern 12b is substantially 0.3 mm. Nickel (Ni) is plated on the surface of the metallic pattern 12b so as to prevent the oxidation. Gold (Au), silver (Ag) or the like may be plated. Since these metals are plated so as to cover the surface of the metallic pattern 12b, it is possible to reliably and effectively reflect light emitted from the semiconductor light-emitting device. Furthermore, it is possible to effectively transfer heat generated in the LED chip 11 to thermal radiation member 14 via the metallic pattern 12b and the metallic member 12c, whereby the more effective radiation is performed.

The plurality of blue LED chips 11 is implemented on the surface of the metallic pattern 12b configured as mentioned above, and the respective LED chips 11 are connected to the metallic pattern 12b by a bonding wire formed of a gold wire. The respective blue LED chips 11 are Riled with a sealing member 12d in which a yellow phosphor is mixed with a transparent silicone resin. The yellow phosphor is excited by the blue LED chip 11 to emit yellow light, and yellow light is mixed with blue light to emit white (including a bulb color, a neutral white, and daylight color). As a result, the substrate 12 is constituted by a so-called Chip on Board (COB) type in which the plurality of LED chips 11 is implemented on the surface side of the DCB substrate.

Furthermore, the metallic member 12c formed of copper plate provided on the back side of the ceramic substrate 12a is constituted by the metallic plate formed of a copper plate thinner than the plate thickness of the metallic pattern 12b provided on the surface side of the ceramic substrate 12a. The thickness of the metallic member 12c is about 0.25 mm. The metallic member 12c is bonded to the back side of the ceramic substrate 12a by the solder and is formed by the flat surface having substantially the same shape as that of the back of the substrate. Nickel (Ni) is plated to the back of the metallic member 12c so as to prevent the oxidation. Gold (Au), silver (Ag) or the like may be plated. In addition, the metallic pattern 12b and the metallic member 12c mentioned above are bonded to the ceramic substrate 12a by the soldering. However, a copper foil may be directly welded to the ceramic substrate 12a by an active metal brazing or may be constituted by a thin metal layer formed by the etching.

As mentioned above, the substrate 12 is constituted which includes the ceramic substrate 12a, the metallic pattern 12b, the LED chip 11, and the metallic member 12c. As mentioned below, in order to form a multifacetedly three-dimensional light source body 16, the light source body 16 forming a quadrangular prism in the present embodiment, that is, a total of five substrates are used, which include four substrates 12 forming a side of the quadrangular prism and one substrate 12 forming the upper surface. These substrates 12 have the same shape.

The thermal radiation member 14 is fixed to the exposed surface of the metallic member 12c of the substrate 12 configured as mentioned above. The thermal radiation member 14 is a member for radiating heat generated from the LED chip 11 implemented in the surface side of the substrate 12, and is formed in a rectangular parallelepiped shape using a metal having satisfactory thermal conductivity, in the present embodiment, copper. Five thermal radiation members 14 of rectangular parallelepiped shape are disposed on four side light-emitting portions and an upper light-emitting portion of the quadrangular prism. The respective thermal radiation members 14 disposed on the side light-emitting portion are formed in a rectangular parallelepiped shape which has one surface of a substantially square shape in which a thickness thereof is about 3 mm and a side thereof is about 15 mm. Similarly, the thermal radiation member 14 disposed in the upper surface light-emitting portion is formed in a rectangular parallelepiped shape which has one surface of a substantially square shape in which a thickness thereof (a height size) is about 17 mm and a side thereof is about 15 mm. That is, the thermal radiation member 14 of four side light-emitting portions surrounds the thermal radiation member 14 of the upper surface light-emitting portion. As mentioned below, the five thermal radiation members 14 constitute the thermal radiation member integrated so as to radiate heat to the main body. An area of a portion forming the plane shape of the thermal radiation member 14 of the rectangular parallelepiped shape is substantially the same as the area of the plane of the substrate 12 in the present embodiment. However, the area of the thermal radiation member may be increased to increase the radiation area.

As mentioned above, the five thermal radiation members 14 configured mentioned above are fixed to the respective metallic members 12c of the five substrates 12 by a fluid fixing member 13 having thermal conductivity before making the light source body 16 described later three-dimensional. The solder is used as the fixing member in the present embodiment from the viewpoint of the thermally conductive performance, fixing intensity or the like. The operation of the soldering is performed by placing the substrate 12 on a flat and horizontal working table so that the metallic member 12c is horizontal, causing the molten solder to flow on the surface of the metallic member 12c, bringing the thermal radiation member 14 into contact with the solder in a molten state, and solidifying and fixing the solder. At this time, on the flat and horizontal working table, when the solder flows in the metallic member 12c formed by the flat surface and the flat thermal radiation member 14 is pressed, the solder does not carelessly flow. Thus, it is possible to reliably fix the metallic member 12c to the thermal radiation member 14 by the simple working suitable for mass production. For example, the automation of the soldering such as a reflow is possible.

In addition, it is also possible to form the thermal radiation member 14 of aluminum, aluminum alloy or the like besides the metal having satisfactory thermal conductivity, for example, copper and copper alloy. In addition, the thermal radiation member may be formed of a synthetic resin such as ceramic and highly thermally conductive resin. Furthermore, the shape of the thermal radiation member 14 is preferably formed in the same shape as that of the substrate 12 so as to form the three-dimensional light source body 16 such as a prism. However, the thermal radiation member 14 may be formed in the size and the shape different from those of the substrate 12. Particularly, in order to effectively exhibit the radiation characteristics, the thermal radiation member 14 may have an area and a thickness greater than that of the substrate 12. Furthermore, the thermal radiation member 14 is fixed by the fluid fixing member 13 having the thermal conductivity, and thus, it is preferable that the surface thereof be formed in a flat plate shape so that the fixing member 13 does not flow. However, a part or the whole thereof may be curved to the extent that the fixing member 13 does not flow, or a warped shape, a groove or the like may be formed in, a surface.

As the fluid fixing member 13 having thermal conductivity, it is suitable to use solder from the viewpoint of the thermal conductivity, the fixing intensity or the like. However, a brazing filler of metal such as a copper, and a fluid resin adhesive formed of, for example, silicone resin, epoxy resin or the like having heat resistance and thermal conductivity may be used.

Incidentally, in a case where, after the substrate 12 is three-dimensionally formed to constitute the light source body 16, the thermal radiation member 14 is fixed to the substrate surface, the substrate 12 placed on the side of the cube is longitudinally placed, and thus the solder flows. Thus, the reliable fixing is a considerably difficult operation. In order to prevent this problem, there is a need to place the substrate 12 horizontally to perform the soldering. Particularly, since there is a need to perform the soldering with respect to each surface of the three-dimensional light source body 16, there is a need to rotate the light source body 16 to perform the positioning each time and perform the operation of the soldering. Thus, the operation is complicated and mass-production is difficult. These operations are to fix the thermal radiation member to the metallic member of the back of the substrate arranged on the inner side (the inner portion space side) of the cube, which is an operation in a narrow space, and the operation is more difficult.

As mentioned above, five light-emitting portions 15 are configured in which the substrate 12 and the thermal radiation member 14 are fixed in advance. In the present embodiment, five blocked light-emitting portions 15, which include four light-emitting portions 15 forming the side light-emitting portion and one light-emitting portion forming the upper surface light-emitting portion (hereinafter, in the case of distinguishing from the side light-emitting portion, referred to as a "light-emitting portion 15a"), are prepared, and the three-dimensional light source body 16 is constituted by placing them on five surfaces with respect to a support member 17, respectively.

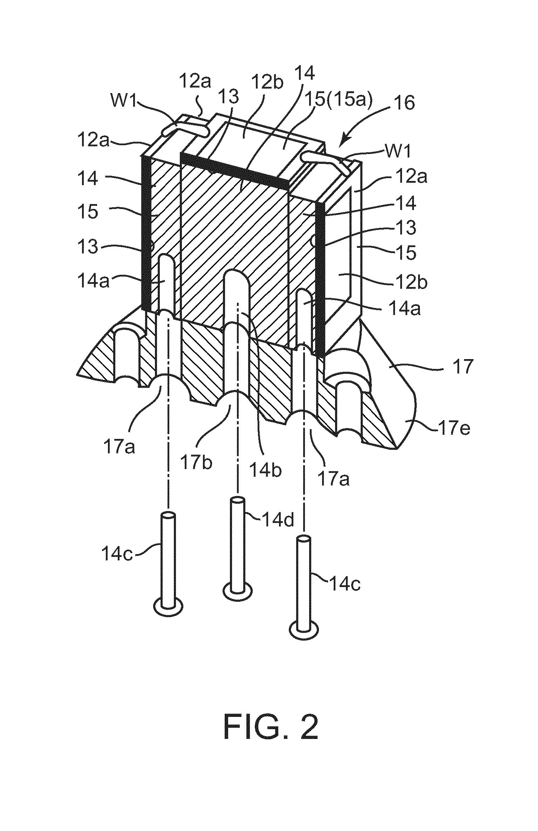

As shown in Fig. 2, the support member 17 is a member which constitutes the light source body 16 forming the three-dimensional quadrangular prism by placing and supporting the plurality of blocked light-emitting portions 15 in the multifaceted shape, and has a function of transmitting heat transmitted to the thermal radiation member 14 to the main body 18 side mentioned below to radiate the same to the outside. The support member 17 is formed of a metal having a satisfactory thermal conductivity like the thermal radiation member 14, for example, copper in the present embodiment, and is formed in a block shape of a thick circular truncated cone. The support member 17 is formed with a sloped conical reflective surface 17e by being formed in a circular truncated cone shape (Mt. Fuji shape), and it is possible to reflect light emitted from the light-emitting portion 15 by the reflective surface 17e.

Four light-emitting portions 15, in which the plurality of blocked light-emitting surfaces form substantially a square shape, are fixed by a screw on the support member 17 with the configuration described above. That is, in the five light-emitting portions 15 and 15a, the four side light-emitting portions 15 forming substantially the square shape constituting the side portion of the quadrangular prism are formed with two screw holes 14a in a bottom surface portion of the rectangular parallelepiped in the state of being vertical to the thermal radiation member 14. Furthermore, the upper surface light-emitting portion 15a of the rectangular parallelepiped shape forming the upper surface portion of the quadrangular prism is formed with a screw hole 14b in the center of the lower surface portion of the thermal radiation member 14.

Meanwhile, the support member 17 is formed with a total of eight insertion holes 17a penetrating from the lower surface to the upper surface of the circular truncated cone corresponding to the screw hole 14a of the thermal radiation member 14, each two in response to the thermal radiation member 14 of the light-emitting portion 15. Furthermore, in the center portion of the circular truncated cone, one insertion hole 17b is formed which penetrates from the lower surface to the upper surface in response to the screw hole 14b of the thermal radiation member 14 in the light-emitting portion 15a of the rectangular parallelepiped.

The thermal radiation member 14 formed with two screw holes 14a and 14a, that is, the light-emitting portions 15 are longitudinally mounted on the two insertion holes 17a formed on the upper surface of the support member 17 of the circular truncated cone shape formed as mentioned above. Two bolts 14c are inserted from the lower surface of the support member 17 into the insertion holes 17a, respectively, and the tip of the bolt 14c is fixed to the screw hole 14a of the thermal radiation member 14 through the screwing. The remaining respective three light-emitting portions 15 are also similarly fixed to the upper surface of the support member 17 by the bolt 14c, and constitute the side portion of the light source body 16 of the quadrangular prism. Furthermore, the light-emitting portion 15a of the rectangular parallelepiped is incorporated into the inner space formed by the four side portions. The light-emitting portion 15a of the rectangular parallelepiped is formed with the screw hole 14b. The bolt 14d is inserted from the lower surface of the support member 17 into the insertion hole 17b, and the tip of the bolt 14d is fixed to the screw hole 14b of the thermal radiation member 14 by the screwing (Fig. 1(a)).

In the four side light-emitting portions 15 and one upper surface light-emitting portion 15a three-dimensionally formed in the quadrangular prism as mentioned above, a portion between positive and negative terminals of each metallic pattern 12a in the substrate 12 is connected by a lead wire w1, and each light-emitting portion is connected by wiring in series. Furthermore, when performing the operation of soldering the thermal radiation member 14 in the metallic member 12c of the light-emitting portion 15 in advance, the five light-emitting portions 15 are concurrently connected by wiring by the lead wire w1 and are mechanically coupled to each other, and the wiring can be performed by folding the same up. That is, the light source body 16 of the quadrangular prism with the wiring mounted thereon in advance is constituted, and the light source body 16 may be fixed to the support member 17 as mentioned above.

As a result, the plurality of light-emitting portions, that is, the four side light-emitting portions 15 and one upper surface light-emitting portion 15a are placed in a multifaceted shape, whereby the three-dimensional light source body 16 is constituted. In addition, the respective insertion holes 17a and 17b are formed in dish holes so that the lower surface of the support member 17 of the circular truncated cone shape is a flat surface, and the respective bolts 14c and 14d also use the bolts formed by the dish screw. Furthermore, an adhesive or a sheet formed of a silicone resin, an epoxy resin or the like having heat resistance and satisfactory thermal conductivity and electrical insulation are interposed between the bottom surface of the thermal radiation member 14 forming the side light-emitting portion 15 of the quadrangular prism and the upper surface portion of the support member 17, and between the bottom surface of the thermal radiation member 14 of the rectangular parallelepiped shape of the light-emitting portion 15a forming the upper surface light-emitting portion and the upper surface portion of the support member 17, whereby the respective thermal radiation members 14 and the support member 17 may be fixed to each other in the thermally adhered state.

In the present embodiment, the light-emitting portion is placed in the multifaceted shape using a plurality of light-emitting portions, for example, five light-emitting portions in which the light-emitting surface includes the light emitting surface of a square shape, and constitutes the three-dimensional light source body formed of the quadrangular prism. Herein, as mentioned above, the plurality of light-emitting portions may be independently constituted, or may be electrically connected in advance by a lead wire, a lead plate connected to the wiring pattern or the like, and may be mechanically connected. Furthermore, the shape of the light source body three-dimensionally formed by placing the plurality of light-emitting portions in the multifaceted shape is not limited to the quadrangular prism, but may be a polygonal prism such as a pentagonal prism, a hexagonal prism, and an octagonal prism, and may be a triangular prism. Furthermore, by forming the light-emitting portion of small pieces and using a number of the small pieces, a substantially cylindrical body shape may be formed, or a substantially circular shape or an elliptically spherical shape may be formed.

In order to effectively perform the radiation of the substrate 12 of the upper surface light-emitting portion 15a, it is desirable to dispose the thermal radiation member 14 of the upper surface light-emitting portion 15a formed so as to form a thick block shape of a metal having satisfactory thermal conductivity in the inner space portion of the cube in the light source body 16 three-dimensionally formed by the side light-emitting portion 15. However, for example, by forming the thermal radiation member 14 of a thick rod-shaped screw member capable of thermally coupling the substrate 12 of the upper light-emitting portion 15a and the support member 17, a part of the inner space portion is kept as a space. Furthermore, the thermal radiation member 14 is not limited to metal, but, for example, may be constituted of an adhesive, a sheet, a block or the like formed of a silicone resin, an epoxy resin or the like having heat resistance and good thermal conductivity and electrical insulation. Furthermore, the thermal radiation members 14 may be formed integrally with the support member mentioned below.

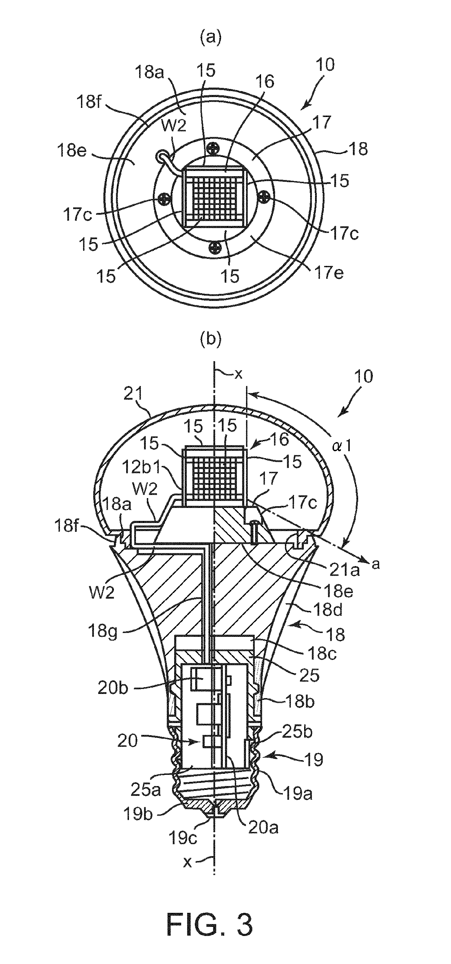

Next, the thermally conductive main body 18 provided with the support member 17 is provided so as to project the three-dimensional light source body 16 to one end portion side as mentioned above, and radiates heat from the LED chip 11 transmitted from the support member 17 to the outside. As shown in Fig. 3, in order to increase the radiation property, a cylindrical shape whose transverse cross-sectional shape has a substantially circular shape formed of a metal having good thermal conductivity, aluminum in the present embodiment, and integrally provided with a large-diameter opening portion 18a on one end portion side and an accommodation concave portion 18c having a small-diameter opening portion 18b on the other end portion side. Furthermore, an outer peripheral surface is formed so as to be a substantially conical taper surface having a diameter gradually reduced from one end portion side toward the other end portion side, and an external form is formed in a shape similar to a silhouette of a neck portion in the electric bulb. On the outer peripheral surface thereon, a plurality of radiation fins 18d radially projected from one end portion side to the other end portion side is integrally formed. The main body 18, for example, process by forging, casting, cutting or the like, and is formed as the thick cylindrical body having a hollow in the inner portion.

The thermally conductive support member 17 thermally coupling and supporting the respective thermal radiation members 14 is a member which has a function as a heat sink for transmitting heat generated in the LED chip 11 to the main body 18 side via the thermal radiation member 14 and radiating heat to the outside. The support member 17 can also be formed of a metal having good thermal conductivity like the thermal radiation member 14, for example, aluminum, aluminum alloy or the like besides the copper and the copper alloy. Furthermore, the support member 17 may be a heat pipe or may be formed of ceramic or a synthetic resin such as a highly thermally conductive resin.

The support member 17 may be formed integrally with the main body 18 so as to effectively transmit heat to the main body side, or the support member 17 may be formed separately from the main body 18 in consideration of the operability during assembling and may be configured by causing the support member 17 and the main body 18 to adhere to each other via an adhesive or the sheet formed of the silicone resin, the epoxy resin or the like having heat resistance and having good thermal conductivity and electrical insulation.

Furthermore, it is desirable that the shape of the support member 17 be formed so as to be projected to one end portion side of the main body 18 so that light emitted from the three-dimensional light source body 16 is, for example, equal to or greater than a 1/2 beam angle of 200° like an electric bulb. However, herein, the condition is not strictly limited to the 1/2 beam angle of 200° or more, but the support member 17 may be projected to the one end portion side so that light is emitted to the back (the surface of the ferrule side). Furthermore, in order to effectively reflect light, the support member 17 is painted in white on the surface thereof, or may be processed to a mirror surface or a half-mirror surface by performing vapor deposition, plating or the like of the metal such as aluminum or silver.

In order to increase the radiation property, the thermally conductive main body 18 is formed of a metal having good thermal conductivity, for example, in addition to aluminum, a metal including at least one kind of copper, iron, and nickel, an industrial material such as aluminum nitride and silicon carbide, or further, a synthetic resin such as a highly thermally conductive resin.

The opening portion 18a of one end portion side of the main body 18 is integrally formed with the light source support portion 18e in which the bottom surface of the concave step portion is formed as the flat surface so that a circular concave step portion is formed, and a concave portion 18f forming the ring shape is integrally formed in the periphery thereof. On a light source body support portion 18e, the support member 17 is provided so that the three-dimensional light source body 16 mentioned above is projected to one end portion side of the main body 18. That is, the flat lower surface of the support member 17 is fixed to the flat light source support portion 18e formed in one end portion side of the main body 18 by the screw 17c so as to have electrical insulation and adhere thereto. Furthermore, the same adheres and is fixed to the surface of the light source body support portion 18e forming the flat surface via the electrical insulation sheet (not shown) formed by the silicone resin or the epoxy resin or the like having the heat resistance and having good thermal conductivity and electrical insulation as necessary.

As mentioned above, the three-dimensional light source body 16 is projected and provided on one end portion side of the main body 18. Moreover, the light source body 16 is provided so that an angle α1 formed between the light-emitting surface of four side light-emitting portions 15 and an outer periphery portion of the light source body support portion 18e in the main body 18, that is, the upper end of the convex portion 18f forming the ring shape is equal to or greater than 90°, and about 115° in the present embodiment, and is equal to or greater than 100°. Thus, the three-dimensional light source body 16 is projected and provided in one end portion of the main body 18 so that light emitted from the light source body 16 is equal to or greater than a 1/2 beam angle of 200° like the electric bulb, and is configured so that light is also emitted to the back (the surface of the ferrule side) (an arrow a in Fig. 3(b)). In the present embodiment, the 1/2 beam angle is, preferably, about 200° to 310°. Therefore, an external form similar to the electric bulb is formed, and it is possible to provide the optimal lamp with ferrule capable of obtaining the targeted light distribution characteristics.

The support member 17 with the light source body 16 fixed thereto reliably adheres to the light source support portion 18e of the main body 18 on the lower surface thereof, and the substrate 12 of the light-emitting portion 15 is formed of thermally conductive ceramic. Furthermore, the thermal radiation member 14 and the support member 17 are formed of copper having good thermal conductivity, and the upper surface light-emitting portion 15a is directly and thermally connected to the support member 17 by the thermal radiation member 14 of the rectangular parallelepiped shape formed of copper. Heat generated from the LED chip 11 disposed in the upper surface and the side is effectively transmitted to the main body 18 formed of aluminum via the members and is radiated to the outside. At this time, heat of the four thermal radiation members 14 forming the side of the quadrangular prism is also conducted to the thermal radiation member 14 of the thermally coupled upper surface light-emitting portion 15a and is more effectively radiated.

In addition, the accommodation concave portion 18c formed integrally with the main body 18 is a concave portion for disposing a circuit board forming the lighting device 20 described later in the inner portion thereof. A transverse cross section thereof forms substantially a circular shape around the center axis x-x of the main body 18. An insulation case 25 is fitted into the accommodation concave portion 18c so as to attain the electrical insulation between the lighting device 20 and the main body 18 formed of aluminum. The insulation case 25 is formed of a synthetic resin having heat resistance and electrical insulation such as PBT (polybutylene terephthalate). One end portion side thereof is formed with an opening portion 25a, and the other end portion side is closed, thereby forming a cylindrical shape having a bottom approximately matched with the inner surface of the accommodation concave portion 18c. The lighting device 20 is fixed into the accommodation concave portion 18c by the screw or an adhesive such as silicone resin and epoxy resin having heat resistance, good thermal conductivity and electrical insulation. One end portion side (the opening portion 25a side) of the insulation case 25 is integrally formed with a ferrule attachment portion 25b having an outer periphery of a step shape.

AS shown in Fig. 3(b), the ferrule member 19 provided on the other end portion side of the main body 18 is a ferrule forming an E 26 shape of an Edison type, and includes a cylindrical shell portion 19a made of a copper plate including a screw thread, and a conductive eyelet portion 19c provided on the top portion of the lower end of the shell portion via the electrically insulating portion 19b. The opening portion of the shell portion 19a is fitted to the ferrule attachment portion 25b of the insulation case 25 from the outside, and is fixed to the other end portion side of the main body by achieving the electrical insulation with the main body 18 by means of the bonding by the adhesive such as silicone resin and epoxy resin having heat resistance and having good thermal conductivity and electrical insulation and the calking. An input wiring derived from the input terminal of the circuit board 20a in the lighting device 20 described later is connected to the shell portion 19a and the eyelet portion 19c.

The lighting device 20 includes a flat plate-shaped circuit board 20a on which the circuit components forming the turn-on circuit of the LED chip 11 are implemented. The turn-on circuit is configured so that the alternating voltage 100 V is converted into the direct voltage 90 V and direct current of constant current is supplied to the respective LED chips 11. On one surface or both surfaces of the circuit board 20a, a circuit pattern of a vertically long shape of the strip shape is formed. A plurality of small electronic components 20b for forming the turn-on circuit such as a lead component such as a small electrolytic capacitor and a chip component such as a transistor is implemented on the mounting surface of the circuit board 20a. The circuit board 20a is longitudinally received in the insulation case 25 provided in the accommodation concave portion 18c of the main body 18 mentioned above. As a result, the lighting device 20 to turn on the LED chip 11 received in the accommodation concave portion 18c in the main body 18 is constituted. Furthermore, a lead wire w2 for supplying electricity to the respective LED chips 11 is connected to the output terminal of the circuit board 20a, and an input wire (not shown) is connected to the input terminal. In addition, the lead wire w2 for supplying electricity is derived from the accommodation concave portion 18c of the main body 18 to one end portion side of the main body 18 via a penetration hole 18g formed through the light source body support portion 18e, and is connected to the input terminal 12b of the light-emitting portion 15 in the light source body 16.

Furthermore, it is advantageous that the lighting device 20 for stably turning on the solid light-emitting device 11 is provided in the main body 18 in view of replacing the light source such as the electric bulb as it is, but can also be differently placed. Furthermore, the lighting device 20 may have a dimming circuit for dimming the solid light-emitting device 11, a toning circuit or the like.

The translucent cover member 21 forms the globe of the lamp, and is formed of synthetic resin such as, for example, polycarbonate having the thin thickness. The translucent cover member 21 is formed of transparent or translucent polycarbonate of milky white having light diffusion property. The translucent cover member 21 has an opening 21a on one end portion side thereof, forming substantially a semi-spherical similar to the silhouette of the electric bulb, and the outer surface is formed to form a smooth curved shape. Moreover, the cover member 21 covers the three-dimensional light source body 16, and the annular fitting portion formed integrally with the opening end portion of the opening 21a fits into the convex portion 18f of the light source body support portion 18e. Furthermore, the cover member 21 is fixed by the adhesive or the like formed of silicone resin, epoxy resin or the like having heat resistance and having good thermal conductivity and electrical insulation. As mentioned above, the cover member 21 is disposed on one end portion of the main body 18, whereby, as shown in Fig. 3(b), the sloped outer peripheral surface of the main body 18 forms an external shape substantially and integrally continuing to the outer peripheral surface of the curved surface shape of the cover member 21 forming the globe, and the entire lamp is formed in a shape similar to the silhouette of the electric bulb.

Next, an assembling order of the lamp with ferrule 10 of the bulb shape configured as mentioned above will be described. Firstly, the insulation case 25 is fitted into the accommodation concave portion 18c of the main body 18, and the adhesive is applied and fixed to the contact portion between the outer peripheral surface of the insulation case 25 and the inner peripheral surface of the accommodation concave portion 18c. Next, the circuit board 20a of the lighting device 20 is vertically set, and is inserted into the insulation case 25. Then the circuit board 20a is fitted into the guide groove to be supported, and is received. At this time, the lead wiring w2 is inserted into the penetration hole 18g and the tip thereof is drawn from one end portion side of the main body 18.

Moreover, the support member 17 on which the light source body 16 three-dimensionally formed in the quadrangular prism in advance is fixed is mounted on the light source body support portion 18e of the main body 18, and four peripheral locations of the support member 17 are fixed from the upper surface side using the screw 17c. At this time, the insulation sheet (not shown) having heat resistance and having good thermal conductivity and electrical insulation is interposed between the upper surface of the light source support portion 18e and the lower surface of the support member 17. As a result, the lower surface of the support member 17 and the flat surface of the light source body support portion 18e adhere and are fixed to each other. Next, the tip of the drawn lead line w2 is connected to the input terminal 12b1 of the light-emitting portion 15 of the fixed light source body 16.

Next, the input line derived from the input terminal of the circuit board 20a of the lighting device 20 is connected to the shell portion 19a of the ferrule member 19 and the eyelet portion 19c, and the opening portion of the shell portion 19a is fitted to the ferrule attachment portion of the insulation case 25 in the connected state and is fixed by the adhesive.

Next, the cover member 21 is prepared and covers the light source body 16 so as to be projected to one end portion side of the main body 18. The annular fitting portion provided in the opening end portion of the opening 21a is fitted into the convex portion 18f of the light source body support portion 18e, and the adhesive is applied to fix the contact portion between the same and the convex portion 18f. As a result, a small bulb-shaped lamp with ferrule 10 is constituted in which the light source body 16 formed of a three-dimensional LED is included. The globe as the cover member 18 is provided in one end portion. Further, the ferrule member 19 of the E 26 shape is provided in the other end portion, and the entire external form is similar to the silhouette of the electric bulb.

In the present invention, the lamp with ferrule may be formed in a shape such as a bulb-shaped lamp with ferrule (an A shape or a PS shape) similar to the shape such as a general electric bulb, a ball-shaped lamp with ferrule (a G shape), a cylindrical-shaped lamp with ferrule (a T shape), and a reflex-shaped lamp with ferrule (an R shape). These lamps may be globe-less lamps with ferrule. Furthermore, the present embodiment is not limited to the lamp with ferrule similar to the shape of the electric bulb, but can be applied to the lamp with ferrule forming various external shapes and for various applications.

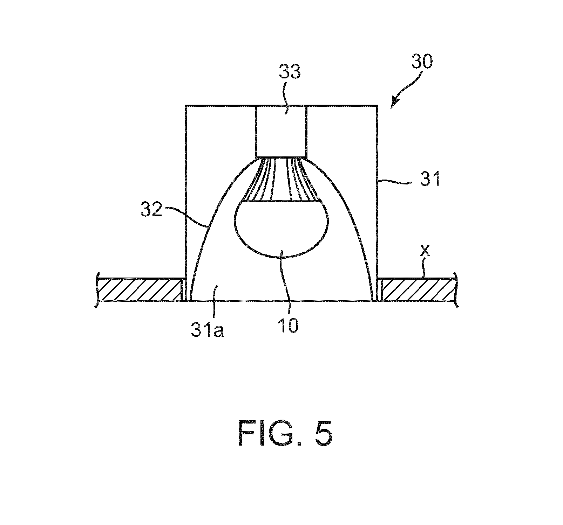

Next, a configuration of the lighting apparatus using the lamp with ferrule 10 configured as mentioned above as the light source will be described. As shown in Fig. 5, the lighting apparatus 30 is an existing lighting apparatus of a down light type which is embedded and installed in a ceiling surface X of a store or the like and uses the electric bulb having the ferrule of E 26 shape as the light source. The lighting apparatus 30 includes a lighting apparatus main body 31 forming a metallic box shape having an opening portion 31a on the lower surface, a metallic reflector 32 fitted to the opening portion 31a, and a socket 33 capable of screwing the ferrule of the E 26 shape of the electric bulb. The reflector 32 is formed of, for example, a metal plate such as stainless steel, and the socket 33 is installed in the middle portion of the upper surface plate of the reflector 32.

In the existing lighting apparatus 30 for an electric bulb configured as mentioned above, on behalf of the electric bulb, the bulb-shaped lamp with ferrule 10 using the LED chip 11 as the light source is used for the purpose of energy saving, longer life or the like,. That is, since the lamp with ferrule 10 has the ferrule member 19 formed in E 26 shape, the lamp with ferrule 10 can be directly plugged into the socket 33 for the electric bulb of the lighting apparatus. At this time, the outer peripheral surface of the lamp with ferrule 10 forms substantially a conical taper surface, and the external form thereof is formed in the shape similar to the silhouette of the neck portion in the electric bulb. Thus, the lamp with ferrule 10 can be smoothly plugged in without the neck portion coming into contact with the reflector 32 or the like around the socket, and the application ratio of the bulb-shaped lamp with ferrule 10 to the existing lighting apparatus is improved. As a result, the down light of energy saving type using the LED chip 11 as the light source is constituted.

When supplying the power source in this state, the power source is supplied from the socket 33 via the ferrule member 19 of the lamp with ferrule 10. The the lighting device 20 is operated, and the direct current voltage of 90 V is output. The direct current voltage is applied from the lighting device 20 to each LED chip 11, and the direct current of constant current is supplied. Thereby, all the LED chips 11 are concurrently turned on, and white light is concurrently emitted from the whole surface of the light-emitting portion 15 in the light source body 16 three-dimensionally formed to the quadrangular prism, that is, a total of five surfaces of the side portion forming four surfaces and the top portion of the quadrangular prism.

At this time, since the three-dimensional light source body 16 is located and projected in the circular center of one end portion side of the main body 18, light is substantially uniformly emitted toward the entire inner surface of the cover member 21. At the same time, the light source body 16 is provided so that the angle α1 formed between the light-emitting surface of the light-emitting portion 15 forming the sides of the quadrangular prism and the upper end of the convex portion 18f forming the ring shape of the light source body support portion 18e in the main body 18 is equal to or greater than 90°, in the present embodiment, 115°, and equal to or greater than 100°, and is provided so as to be projected to the one end portion side of the main body 18 so that the angle is equal to or greater than a 1/2 beam angle of 200°. As a result, particularly, light is also sufficiently emitted to the back (the surface of the ferrule side), and the light is diffused by the milky white globe. Thus, it is possible to obtain sufficient reflection performance as the optical design formed as the reflection plate for the electric bulb, and it is possible to perform the lighting having substantially the same light distribution characteristics as those of the electric bulb.

Incidentally, in the lamp with ferrule of the related art, since the LED which becomes the light source is placed on the surface of the substrate in a plane shape, light emitted from the LED is mainly emitted to the front surface side, and the same light distribution characteristics as those of the electric bulb are not obtained. Particularly, the uniform light distribution characteristics toward substantially all directions including the back are not obtained. For this reason, in the lighting apparatus having the reflection plate optically designed by originally using the electric bulb as the light source, there is a problem in that it is impossible to obtain sufficient reflection characteristics as the optical design.

In the present embodiment, the ceiling embedding type, a direct attachment type, a pendant type, a wall surface attachment type or the like may be applied to the lighting apparatus. A member in which a globe, a shade, a reflector or the like are attached to the lighting apparatus main body as the light control body, and a member in which the lamp with ferrule which becomes the light source is exposed, may be used as the lighting apparatus. Furthermore, a plurality of lamps with ferrule may be disposed without being limited to the construction in which one lamp with ferrule is attached to the lighting apparatus main body 1. Furthermore, a large lighting apparatus for facilities and businesses such as an office or the like may be configured. Furthermore, the lighting apparatus may be one designed for an electric bulb, and may be one designed specifically for a lamp with ferrule which uses the solid light-emitting device as the light source.

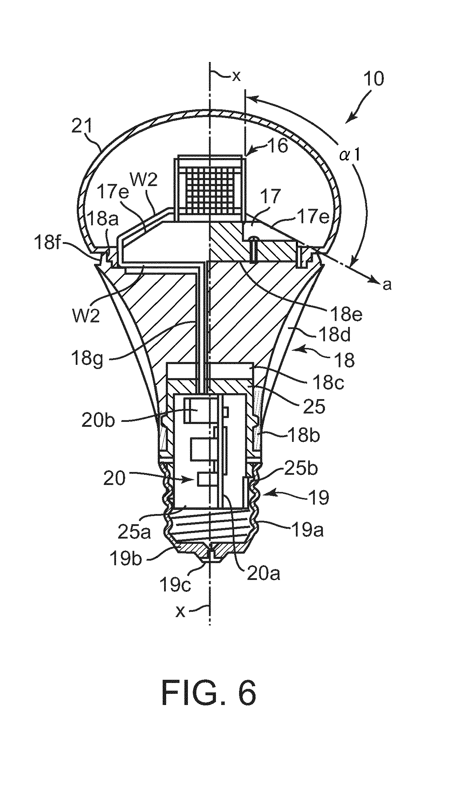

Fig. 6 shows a first modified example of the present embodiment. In the present modified example, as shown in Fig. 6, the support member 17 is configured so that the reflective surface 17e of the circular truncated cone shape is extended to the end portion of the light source body support portion 18e, that is, the vicinity of the ring-shaped convex portion 18f. In this case, the angle α1 formed between the slope portion of the reflective surface 17e and the light-emitting surface of the light-emitting portion 15 is equal to or greater than 90°, in the present embodiment, about 113°, and is equal to or greater than 100°. As a result, due to the reflective surface 17e having the expanded area, light can be more effectively reflected, and a 1/2 beam angle of 200° or more can be reliably set.

Moreover, the surface of the reflective surface 17e may be painted in white. Furthermore, the surface of the light source body support portion 18e of the main body 18 fixing the light source body 16 may also be painted in white. By performing the white painting, it is possible to provide a lamp with ferrule which allows higher flux due to the improvement in extraction of light without light loss.

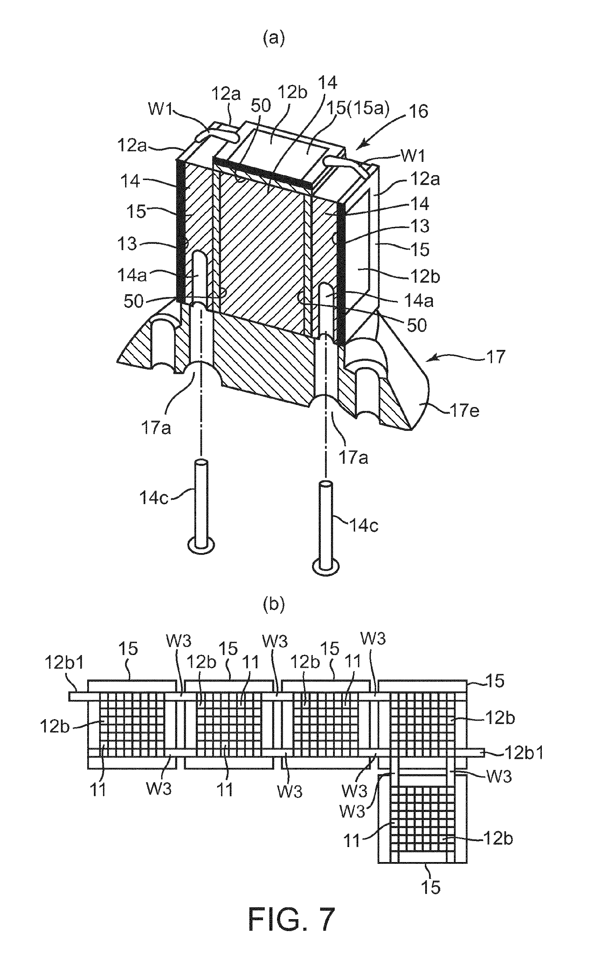

Fig. 7(a) shows a second modified example of the present embodiment. As shown in Fig. 7(a), the thermal radiation member 14 provided in the substrate 12 of the upper surface light-emitting portion 15a forms the rectangular parallelepiped shape so as to radiate heat of the substrate 12 and is placed so as to be thermally and directly coupled to the support member 17, but may be formed integrally with the support member 17. With this configuration, there is no thermal resistance in the coupling portion between the thermal radiation member 14 and the support member 17, and the radiation operation can be more effectively performed. Furthermore, there is no need for the operation for fixing the thermal radiation member 14 of the rectangular parallelepiped shape to the support member 17 and a screw, an adhesive, and a sheet for fixing, whereby it is possible to provide a lamp with ferrule which is also favorable in terms of cost.

In this manner, it is desired that when integrally forming the thermal radiation member 14 and the support member 17, the thermal coupling between the metallic member 12c of the back side of the substrate 12 of the upper surface light-emitting portion 15a and the upper surface of the thermal radiation member 14 forming the rectangular parallelepiped, that is, the upper surface of the support member 17 is interposed via the thermally conductive member 50 such as an adhesive and a sheet formed of silicone resin, epoxy resin or the like having thermal resistance and good thermal conductivity and electrical insulation. As a result, heat generated by the LED chip 11 provided in the upper surface portion of the quadrangular prism can also be effectively transmitted to the main body 18 side via the thermal radiation member 14 of the rectangular parallelepiped and the support member 17. Furthermore, by also interposing the thermally conductive member 50 such as the adhesive and sheet between the support member 17 and the four thermal radiation members 14 (the thermal radiation members 14 forming the side portion of the quadrangular prism) located in the inner surface of the quadrangular prism, the four thermal radiation members 14 may thermally adhere to the thermal radiation member 14 of the rectangular parallelepiped shape of the upper surface light-emitting portion 15a placed in the inner space. As a result, it is possible to more reliably transmit heat generated from the LED chip 11 placed on each surface including the upper surface of the quadrangular prism to the main body 18 side via the thermal radiation member 14 of the rectangular parallelepiped shape placed in the inner space and the support member 17, whereby the radiation can be more effectively performed.

Furthermore, the support member 17 supporting the light-emitting portion 15 is formed in the circular truncated cone shape, but may be formed in the rectangular parallelepiped shape. The support member 17 of the circular truncated cone shape and the rectangular parallelepiped shape may be formed so as to be integrally projected from the light source body support portion 18e of the main body 18. In this case, the main body 18 and the support member 17 may be integrally formed of aluminum, and may be integrally formed of copper. According to the configuration, there is no thermal resistance in the coupling portion between the support member 17 and the main body 18. Thus, the radiation operation can be more effectively performed, and there is no need for the operation for fixing the support member 17 and the screw, the adhesive and the sheet for fixing, whereby it is possible to provide a lamp with ferrule which is also favorable in terms of cost. Furthermore, as shown in Fig. 7(a), by integrally forming the thermal radiation member 14 of the rectangular parallelepiped shape and the support member 17 and integrally forming the support member 17 and the main body 18, the radiation operation can be more effectively performed. According to the configuration, it is possible to provide a lamp with ferrule which is even more favorable in terms of cost.

Fig. 7(b) shows a third modified example. In the present embodiment, the wiring of the plurality of light-emitting portions 15 is performed by connecting the lead wire w1 after three-dimensionally forming the light source body 16 to the quadrangular prism. However, as shown in Fig. 7(b), the metallic pattern 12b of the substrate 12 in each light-emitting portion 15 may be connected by the integrally extended lead plate w3 to perform the wiring connection in advance, and the pre-wired light source body 16 of the quadrangular prism may be configured by folding up each lead plate w3 as the folding wiring to be fixed to the support member 17. According to the configuration, since there is no need for the soldering operation of the lead wire w1, the operation is simplified, and it is possible to provide a lamp with ferrule which is more suitable for mass production.

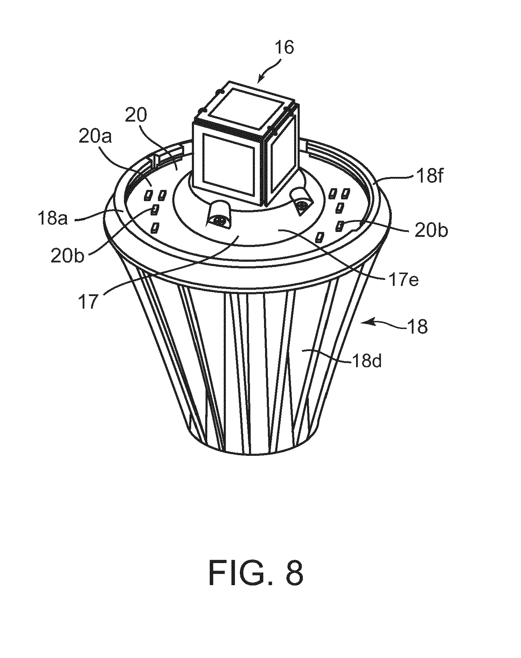

Fig. 8 shows a fourth modified example. In the present modified example, the circuit board 20a of the lighting device 20 is provided in the light source body support portion 18e of the main body 18. That is, as shown in Fig. 8, the circuit board 20a is formed in the ring shape, and the circuit component 20b is implemented on the substrate surface side. The circuit board 20a is mounted on the light source body support portion 18e formed of the flat surface so as to surround the support member 17 with the light source body 16 fixed thereto, and is fixed by the fixing means such as a screw via the adhesive including silicone resin, epoxy resin or the like having heat resistance and having good thermal conductivity and electrical insulation, or the sheet made of these resin. According to this, heat generated from the circuit component 20b can also be radiated from the main body 18 to the outside via the light source body support portion 18e, whereby it is possible to promote the improvement in reliability of the circuit and longer life. At the same time, since the circuit board 20a is accommodated by the use of a ring-shaped gap formed around the light source body 16, there is no need for the insulation case 25 for accommodating the circuit board mentioned above or the like, which is also favorable in terms of cost. Furthermore, by covering the surface of the circuit board 20a with the white resist, light emitted from the light source body 16 can be effectively reflected. Thus, it is possible to provide a lamp with ferrule which allows the higher flux without loss of the light extraction.

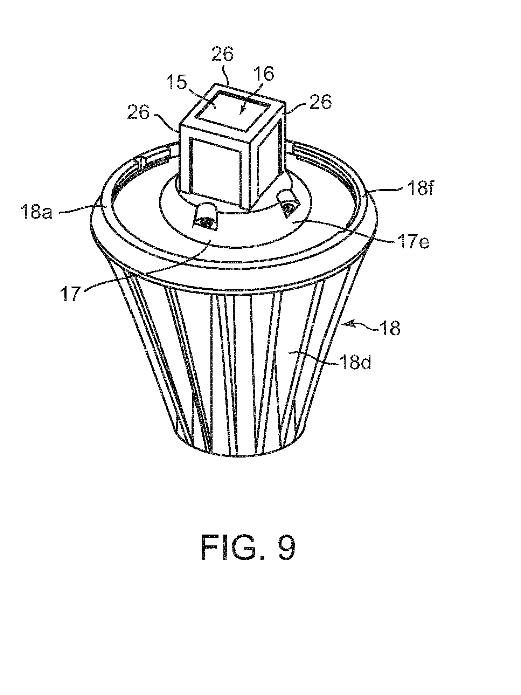

Fig. 9 shows a filth modified example. A portion, which is a ridge of the light source body 16 formed of the quadrangular prism formed by assembling the light source portion to the multifaceted shape, absorbs light and becomes a dark portion. In order to prevent this, in this modified example, as shown in Fig. 9, a frame-like closing side 26 formed of white synthetic resin, for example, a resin such as PBT having heat resistance and electrical insulation is prepared, and the frame-like closing side 26 covers the ridge portion from the upper part of the light source body 16 of the quadrangular prism. The frame is fixed by the adhesive formed of silicone resin, epoxy resin or the like having heat resistance and having good thermal conductivity and electrical insulation. According to the configuration, light emitted from the light source portion is not absorbed by the ridge portion, light is effectively reflected by the white closing side 26, whereby it is possible to provide a lamp with ferrule which allows a higher flux by the improvement in extraction efficiency of light. In addition, even when the ridge which becomes the dark portion is blocked by applying white paint having heat resistance on behalf of the closing side 26, the same working effect can be exhibited.

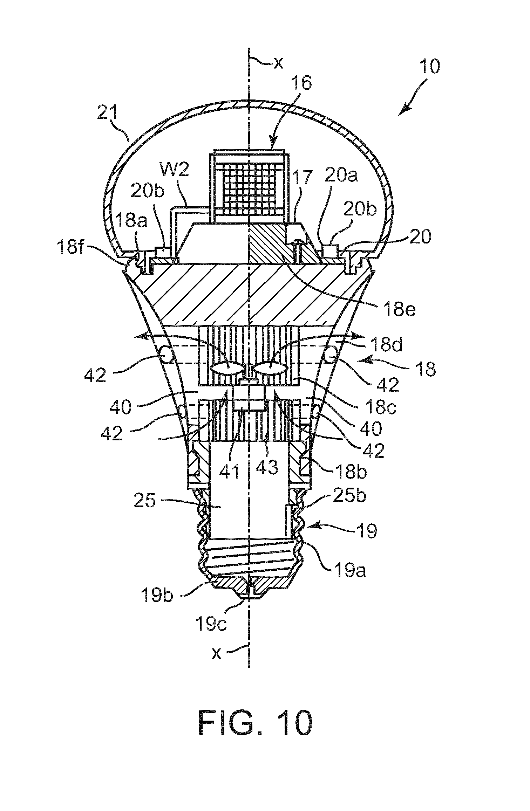

Fig. 10 shows a sixth modified example. According to the modified example, in the lamp with ferrule configured as mentioned above, in order to further increase the radiation effect and improve the light-emitting effect, heat of the LED chip is radiated by forced air-cooling. That is, as shown in Fig. 10, a support portion 40 is radially and integrally formed in the accommodation concave portion 18c forming the cylindrical form of the main body 18, and a fan motor 41 is fixed to the center of the support portion 40. Moreover, a plurality of horizontal long ventilation holes 42 penetrating from the inner wall surface of the accommodation concave portion 18c to the outside is radially formed, and a plurality of radiation fins 43 along the center axis (the center axis x-x of the main body 18) of the accommodation concave portion 18c is formed. The radiation fins 43 are to effectively radiate heat from the light source body 16 transmitted to the accommodation concave portion 18c via the support member 17. In addition, as shown in Fig. 8, the circuit board 20a of the lighting device 20 is provided so as to surround the support member 17 on the light source body support portion 18e on one end portion side of the main body 18.

According to the configuration mentioned above, when the lamp with ferrule 10 is turned on, the fan motor 41 is always rotated, as indicated by an arrow in Fig. 10. Thereby, outdoor air from the outside is taken into the accommodation concave portion 18c of the main body 18 via the horizontal long ventilation hole 42 penetrating from the inner wall of the accommodation concave portion 18c to the outside, and the warmed air by cooling the radiation fins 43 is discharged to the outside. In addition, by reversing the motor rotation by a switch depending on the installation location of the lamp, the outdoor air may be taken from a direction opposite to the arrow. By such an operation, heat of the LED chip 11 transmitted to the main body 18 via the thermal radiation member 14 and the support member 17 is forcibly discharged to the outside by the fan motor 41. Accordingly, the radiation operation is more effectively performed, and it is possible to remarkably improve the light-emitting efficiency of the LED chip 11.
With the present embodiment, it is possible to provide a lamp with ferrule which includes excellent light distribution characteristics, radiation property and improved light-emitting efficiency. Furthermore, by using the lamp with ferrule of the present embodiment, it is possible to provide the lighting apparatus which has sufficient reflective performance as the optical design and has a long life.

While certain embodiments have been described, these embodiments have been presented by way of embodiment only, and are not intended to limit the scope of the inventions. In practice, the structural elements can be modified without departing from the spirit of the invention. Various embodiments can be made by properly combining the structural elements disclosed in the embodiments. For embodiment, some structural elements may be omitted from all the structural elements disclosed in the embodiments. Furthermore, the structural elements in different embodiments may properly be combined. The accompanying claims and their equivalents are intended to cover such forms or modifications as would fall with the scope and spirit of the inventions.

The present application puts a priority basis to the benefit of preceding Japanese Patent Application No. 2010-037510 filed on February 23, 2010, and seeks the profits thereof, the entire contents of which are hereby incorporated by reference.

### REFERENCE SIGNS LIST

- 10: lamp with ferrule
- 11: solid light-emitting device
- 12: substrate
- 13: fixing member
- 14: thermal radiation member
- 15: light-emitting portion
- 16: light source body
- 17: support member
- 18: main body
- 19: ferrule member
- 20: lighting device
- 21: cover member
- 30: lighting apparatus
- 31: lighting apparatus main body
- 33: socket

## Claims

1. A lamp with ferrule comprising:
a substrate including a solid light-emitting device implemented on one surface side thereof;
a thermal radiation member fixed to the other surface side of the substrate by a fluid fixing member having thermal conductivity;
a light-emitting portion constituted by the substrate and the thermal radiation member;
a thermally conductive support member for constituting a three-dimensional light source body using a plurality of light-emitting portions, and thermally coupling and supporting the thermal radiation member;
a thermally conductive main body provided with the support member so as to project the three-dimensional light source body to the one end portion side thereof; and
a ferrule member provided on the other end portion side of the main body.

2. The lamp with ferrule according to claim 1,
wherein the three-dimensional light source body is provided so as to be projected to the one end portion side of the main body to have characteristics of a 1/2 beam angle of 200° or more.

3. The lamp with ferrule according to claim 1,
wherein the light source body is formed in a prism shape, and includes a side light-emitting portion placed on a side of the prism and an upper surface light-emitting portion placed on an upper surface of the prism.

4. The lamp with ferrule according to claim 3,
wherein the side light-emitting portion forms an inner space, and the thermal radiation member of the upper surface light-emitting portion is placed in the inner space.

5. The lamp with ferrule according to claim 3,
wherein the side light-emitting portion and the upper surface light-emitting portion are formed in a substantially rectangular parallelepiped shape, and the respective thermal radiation members of the side and upper surface light-emitting portions are attached so that one surface of the rectangular parallelepiped adheres to the support member.

6. The lamp with ferrule according to claim 4,
wherein the respective thermal radiation members of the side light-emitting portion are thermally coupled to the thermal radiation member of the upper surface light-emitting portion.

7. The lamp with ferrule according to claim 4,
wherein the respective thermal radiation members of the side light-emitting portion are thermally coupled to the thermal radiation member of the upper surface light-emitting portion by thermally conductive and electrically insulating materials.

8. The lamp with ferrule according to claim 1,
wherein the support member is formed in a circular truncated cone shape including a slope surface which reflects light from the light-emitting portion.

9. The lamp with ferrule according to claim 3, further comprising:
a frame member which covers a ridge portion of the prism forming the light source body.

10. The lamp with ferrule according to claim 3,
wherein the ridge portion of the prism forming the light source body is covered by white resin.

11. A lamp with ferrule comprising:
a light source body supporting portion provided with a light source body thereon;
a thermally conductive main body formed in a substantially circular truncated cone shape having one end larger than the other end portion, and forming the light source body supporting portion in the one end portion;
a ferrule member provided in the other end portion of the main body and connected to the light source body; and
a thermally conductive support member arranged on the light source body supporting portion so as to be projected from the main body and mount the light source body thereon;
wherein the light source body includes a plurality of light emitting portions, each light emitting portion including;
a substrate having a solid light-emitting device mounted on one surface side thereof, and
a thermal radiation member fixed to the other surface side of the substrate by a fluid fixing member having thermal conductivity, and
wherein the light source body is three-dimensionally formed using the plurality of light-emitting portions.

12. The lamp with ferrule according to claim 11,
wherein the support member is formed in a circular truncated cone shape including a slope surface which reflects light from the light-emitting portion.

13. The lamp with ferrule according to claim 11,
wherein a circuit board with electronic components mounted thereon is placed on the light source body supporting portion so as to surround the support member.

14. The lamp with ferrule according to claim 13, wherein the circuit board is painted in white.

15. The lamp with ferrule according to claim 13,
wherein the main body includes an accommodation concave portion and a forced air-cooling device accommodated in the accommodation concave portion.

16. The lamp with ferrule according to claim 15, further comprising:
a plurality of thermal radiation fins formed in an inner wall of the accommodation concave portion to radiate heat transmitted from the light source body to the accommodation concave portion.

17. The lamp with ferrule according to claim 12,
wherein the sloped surface of the support member of the circular truncated cone shape is formed so as to be extended to the end portion of the light source body supporting portion.

18. Alighting apparatus comprising:
a lighting apparatus main body provided with a socket; and
a lamp with ferrule mounted in the socket of the lighting apparatus main body,
wherein the lamp with ferrule includes;
a substrate in which a solid light-emitting device is implemented on one surface side thereof,
a thermal radiation member fixed to the other surface side of the substrate by a fluid fixing member having thermal conductivity,
a light-emitting portion constituted by the substrate and the thermal radiation member,
a thermally conductive support member constituting a three-dimensional light source body using a plurality of light-emitting portions, and thermally coupling and supporting the thermal radiation member,
a thermally conductive main body provided with the support member so as to project the three-dimensional light source body to the one end portion side, and
a ferrule member provided on the other end portion side of the thermally conductive main body.

19. The lamp with ferrule according to claim 18,
wherein the three-dimensional light source body is provided so as to be projected to the one end portion side of the main body to have characteristics of a 1/2 beam angle of 200° or more.
